# EUROPÄISCHE PATENTSCHRIFT

(11) **EP 4 006 351 B1**
(45) Veröffentlichungstag und Bekanntmachung des Hinweises auf die Patenterteilung: **21.10.2026**
(21) Anmeldenummer: 21209889.1
(22) Anmeldetag: 23.11.2021
(51) Int. Cl.: H05K 3/341, H05K 3/3452, F04D 25/06

(54) **KREISELPUMPE MIT EINEM MOTOR**
CENTRIFUGAL PUMP WITH A MOTOR
POMPE CENTRIFUGE DOTÉE D'UN MOTEUR

(30) Priorität: 26.11.2020 LU 102244
(43) Veröffentlichungstag der Anmeldung: 01.06.2022
(73) Patentinhaber: WILO SE, 44263 Dortmund (DE)
(72) Erfinder: BROCKMANN, Markus, 44263 Dortmund (DE); FREVEL, Stephan, 44263 Dortmund (DE); RIEDL, Rüdiger, 44263 Dortmund (DE); HELLMICH, Nils, 44263 Dortmund (DE)
(74) Vertreter: Michalski Hüttermann & Partner mbB

(56) Entgegenhaltungen:
- DE-U1- 202008 015 028
- US-A1- 2003 064 546
- US-A1- 2012 051 904
- US-A1- 2017 119 946

## Beschreibung

### Technisches Gebiet

Die Erfindung betrifft eine Kreiselpumpe mit einem Motor, einem von dem Motor antreibbaren Laufrad zum Fördern eines Fluids und einer Steuerung, welche zum Steuern des Motors eingerichtet ist, wobei die Steuerung eine Leiterplatte mit wenigstens auf einer Oberseite der Leiterplatte vorgesehenem elektronisches Bauelement aufweist. Die Erfindung betrifft ferner Verfahren zum Herstellen einer Kreiselpumpe mit einem Motor, einem von dem Motor antreibbaren Laufrad zum Fördern eines Fluids und einer Steuerung mit einer Leiterplatte, welche Steuerung zum Steuern des Motors eingerichtet ist, mit dem Schritt Aufsetzen eines elektronischen Bauelements auf eine Oberseite der Leiterplatte.

### Hintergrund der Erfindung

Kreiselpumpen sind aus dem Stand der Technik bekannt und dienen zur Förderung eines Fluids mittels einer Drehbewegung eines in der Kreiselpumpe vorgesehenen Laufrads. Das Laufrad wird mittels einer Rotorwelle durch einen Motor der Kreiselpumpe angetrieben. Gesteuert werden derartige Kreiselpumpen durch eine Steuerung, welche wenigstens ein mit einer Leiterplatte vorgesehenes elektronische Bauelement, beispielsweise einen Mikroprozessor und/oder einen Kondensator, aufweist.

Bei der sogenannten Durchsteckmontage bzw. englisch through-hole technology, abgekürzt THT, werden Drahtanschlüsse des elektronischen Bauelements durch Kontaktlöcher der Leiterplatte geführt und mittels Verlöten elektrisch mit Leiterbahnen der Leiterplatte verbunden. Bei der industriellen Herstellung derartiger Leiterplatten entstehen nicht selten defekte Lötstellen, insbesondere bei elektronischen Bauelementen mit drei oder mehr Drahtanschlüssen, welche Kontaktunterbrechungen verursachen. In der Folge muss die Leiterplatte der Kreiselpumpe in manueller Weise aufwendig nachgearbeitet werden.

US 2017/119946 A1 beschreibt Techniken zum Befestigen eines Sensors.

US 2003/064546 A1 beschreibt eine Vorrichtung, die ein Substrat, eine oder mehrere Kontaktstellen in dem Substrat und eine oder mehrere Entlüftungen in mindestens einem der einen oder mehreren Durchkontaktierungspads aufweist.

### Beschreibung der Erfindung

Ausgehend von dieser Situation ist es eine Aufgabe der vorliegenden Erfindung, eine Kreiselpumpe und ein entsprechendes Herstellungsverfahren für eine Kreiselpumpe anzugeben, deren Leiterplatte bei der Herstellung keine oder jedenfalls eine wesentlich geringere Anzahl defekter Lötstellen aufweist.

Die Aufgabe der Erfindung wird durch die Merkmale der unabhängigen Ansprüche gelöst. Vorteilhafte Ausgestaltungen sind in den Unteransprüchen angegeben.

Demnach wird die Aufgabe gelöst durch eine Kreiselpumpe mit einem Motor, einem von dem Motor antreibbaren Laufrad zum Fördern eines Fluids und einer Steuerung, welche zum Steuern des Motors eingerichtet ist, wobei
die Steuerung eine Leiterplatte mit wenigstens auf einer Oberseite der Leiterplatte vorgesehenem Lötstopplack, Kontaktlöcher, wenigstens auf einer Unterseite der Leiterplatte vorgesehene Leiterbahnen und wenigstens ein auf der Oberseite vorgesehenes elektronisches Bauelement mit wenigstens drei Drahtanschlüssen aufweist, welche durch die Kontaktlöcher hindurchgeführt und auf der Unterseite mit den Leiterbahnen derart verlötet sind, dass das elektronische Bauelement berührend auf dem Lötstopplack aufliegt, und
der Lötstopplack zwischen dem elektronischen Bauelement und der Leiterplatte wenigstens zum Teil ausgespart ist und sich der ausgesparte Teil zwischen wenigstens einem und vorzugsweise allen Kontaktlöchern bis neben das elektronische Bauelement erstreckt, so dass von den Kontaktlöchern ein Gas in die Umgebungsluft entweichen kann.

Ein wesentlicher Punkt der vorgeschlagenen Lösung liegt darin, dass der Lötstopplack wenigstens zum Teil unter dem elektronischen Bauelement ausgespart ist und sich der ausgesparte Teil bis neben das elektronische Bauelement erstreckt, so dass beim Verlöten der Drahtanschlüsse mit den Kontaktlöchern bzw. den Leiterbahnen das durch das Verlöten entstehende Gas durch den ausgesparten Teil neben das elektronische Bauelement entweichen kann. Aufgrund der wenigstens drei Drahtanschlüsse ist das berührend auf dem Lötstopplack aufliegende elektronische Bauelement ortsfest auf der Leiterplatte fixiert. Beim Verlöten der Drahtanschlüsse mit den Leiterbahnen entstehen durch Verdampfen eines zum Verlöten benutzen Lots Gase in Form von Lötdämpfen. Sofern das elektronische Bauelement wie beschrieben ortsfest auf der Leiterplatte fixiert ist, können bei aus dem Stand der Technik bekannten Ausgestaltungen Gase von der Lötstelle nicht zwischen dem elektronischen Bauelement und der Leiterplatte in die Umgebungsluft entweichen. Stattdessen entweichen die Gase durch das im Verlöten befindliche Kontaktloch, so dass an dem Kontaktloch eine schadhafte Lötstelle, teils auch kalte Lötstelle genannt, entsteht. Eine schadhafte Lötstelle führt entweder unmittelbar oder nach einiger Zeit zu einer Kontaktunterbrechung und Kontaktunsicherheit zwischen dem betreffenden Drahtanschluss und der Leiterbahn, die aufwendig nachgearbeitet und repariert werden muss. Durch die vorgeschlagene Ausgestaltung, bei der von dem Kontaktloch Gas in die Umgebungsluft entweichen kann, werden schadhafte Lötstellen verhindert, so dass die mit der Leiterplatte versehenen vorgeschlagenen Kreiselpumpen durch wesentlich weniger Kontaktunterbrechungen und Kontaktunsicherheiten bei der Herstellung gekennzeichnet sind.

Als Kreiselpumpe wird im Allgemeinen eine Strömungsmaschine bezeichnet, die eine Drehbewegung und dynamische Kräfte zur Förderung überwiegend von Flüssigkeiten als Fluid nutzt. Neben einer tangentialen Beschleunigung des Fluids, auch Medium genannt, wird in radialer Strömung auftretende Fliehkraft zur Förderung genutzt, so dass Kreiselpumpen ebenso als Zentrifugalpumpen bezeichnet werden. Im regulären Betrieb der Kreiselpumpe ist ein Gehäuse des Motors bevorzugt oberhalb eines Pumpengehäuses angeordnet, in welchem ein von dem Motor über die Rotorwelle angetriebenes Laufrad zum Fördern des Fluid vorgesehen ist, wobei das Gehäuse des Motors mit dem Pumpengehäuse ortsfest verbunden und/oder einteilig gestaltet sein kann. Das Fluid umfasst bevorzugt Wasser oder ein sonstiges flüssiges Medium wie beispielsweise Abwasser. Bevorzugt ist das Gehäuse des Motors aus Metall, insbesondere aus Edelstahl, und/oder das Pumpengehäuse aus Kunststoff gestaltet.

Die Steuerung, auch Steuerungsreinrichtung genannt, umfasst bevorzugt einen Mikrocontroller, einen Mikroprozessor, einen integrierten Schaltkreis oder dergleichen als elektronische Bauelement, mittels derer der Motor der Pumpe steuerbar ist, beispielsweise aufgrund eines vorgegebenen und/oder einstellbaren Programms und/oder aufgrund von Eingangsinformationen, wie Sensoren. Die Leiterplatte, auch Leiterkarte, Platine oder gedruckte Schaltung, englisch printed circuit board, PCB, genannt, ist bevorzugt aus einem elektrisch isolierendem Material mit daran haftenden, leitenden Verbindungen, den Leiterbahnen, gestaltet. Als isolierendes Material findet bevorzugt faserverstärkter Kunststoff Verwendung. Die Leiterplatte kann als einseitige, zweiseitige oder multilayer Leiterplatte gestaltet sein, jeweils mit Leiterbahnen auf nur einer Seite, auf beiden Seiten und zwischen und/oder auf wenigstens einer Schicht als layer.

Die Kontaktlöcher stellen im Wesentlichen Bohrungen dar, durch welche die Drahtanschlüsse hindurchführbar sind. Die insbesondere aus Kupfer ausgeführten Leiterbahnen können entweder direkt an die Kontaktlöcher heranreichen, so dass die Drahtanschlüsse unmittelbar mit den Leiterbahnen verlötet werden können. Ebenso können um die Kontaktlöcher sogenannte Lötaugen, Lötflächen und/oder Pads vorgesehen, welche einerseits elektrisch leitend mit den Leiterbahnen verbunden sind, insbesondere einstückig ausgeführt sind, und mit welchen andererseits die Drahtanschlüsse verlötet werden können. In jedem Fall wird eine gleichzeitige mechanische Fixierung und elektrische Verbindung zwischen dem elektronischen Bauelement und der Leiterplatte erreicht. Die Leiterbahnen können auch Kupferflächen umfassen und/oder als Kupferflächen ausgeführt sein.

Die Leiterplatte kann beidseitig auf ihrer Oberseite und Unterseite mit Lötstopplack versehen sein, insbesondere kann die vollständige Oberfläche der Leiterplatte mit Lötstopplack bedeckt sein. Lötstopplack, auch Lötstoppmaske, Soldermask oder Stopplack genannt, dient in der Regel zum Schutz der Leiterbahnen aus Kupfer vor Korrosion, zum Schutz vor mechanischer Beschädigung der Leiterplatte, verhindert beim Löten ein Benetzen der mit ihm überzogenen Oberflächen auf der Leiterplatte und/oder verbessert elektrische Eigenschaften wie die Durchschlagsfestigkeit. Optisch ist Lötstopplack häufig in Grün ausgeführt, jedoch sind auch andere Farben wie rot, blau oder weiß möglich. Als Material für Lötstopplack kommt beispielsweise Epoxidharz in Frage. Die Dicke des Lötstopplacks, auf der Leiterplatte in einem Bereich ohne Leiterbahn, ist in der Regel ≥ 10 µm und ≤ 25 µm, kann jedoch ebenso ≥ 20 µm und ≤ 40 µm bis hin zu beispielsweise 50 µm betragen. Die Dicke des Lötstopplacks auf einer Leiterbahn kann ≥ 10 µm und ≤ 25 µm betragen.

Die Drahtanschlüsse sind durch die Kontaktlöcher insbesondere mittels sogenannter Durchsteckmontage oder auch Einsteckmontage, englisch through-hole technology, THT, oder pin-in-hole technology, PIH, hindurchgeführt und auf der Unterseite mit den Leiterbahnen bzw. via Lötausgen verlötet. Das Verlöten kann durch konventionelles Handlöten, Wellenlöten oder Selektivlöten erfolgen. Das derart verlötete elektronische Bauelement liegt mit seiner Unterseite berührend auf dem Lötstopplack auf. Aufgrund der wenigstens drei Drahtanschlüsse ist das elektronische Bauelement ortsfest auf der Leiterplatte gehalten. Bei aus dem Stand der Technik bekannten Ausgestaltungen kann aufgrund der berührenden Auflage beim Verlöten entstehenden Gas nicht zwischen Leiterplatte und der Unterseite des elektronischen Bauelements entweichen. Dieses Gas entweicht daraufhin durch eines der Kontaktlöcher und verursacht in der Folge eine defekte Lötstelle an dem betreffenden Kontaktloch, welche aufwendig manuell nachgearbeitet werden muss, um eine dauerhaft verlässliche elektrische Kontaktierung zwischen Drahtanschluss und Leiterbahn zu erhalten.

Zur Lösung dieses Problems wird bei der vorgeschlagenen Lösung der Lötstopplack zwischen dem elektronischen Bauelement und der Leiterplatte wenigstens zum Teil ausgespart. Der ausgesparte Teil erstreckt sich einerseits bevorzugt zwischen allen Kontaktlöchern, so dass beim Verlöten entstehendes Gas von jedem Kontaktloch entweichen kann, sowie andererseits bis neben das elektronische Bauelement, so dass das Gas nicht durch das Kontaktloch sondern neben das elektronische Bauelement entweichen kann. Der derart ausgesparte Teil kann kanalartig gestaltet sein, wie im Folgenden näher beschrieben. Da das elektronische Bauelement berührend auf dem Lötstopplack aufliegt, jedoch das Gas neben das elektronische Bauelement entweichen kann, liegt das elektronische Bauelement beispielsweise an seinem Rand abwechselnd auf dem Lötstopplack auf, wobei der aufliegende Bereich von den genannten Kanälen unterbrochen ist. Der ausgesparte Teil, auch Bereich genannt, kann sich um alle Drahtanschlüsse herum diese einfassend erstrecken, oder beispielsweise nur einseitig an den Drahtanschluss diesen gastechnisch anschließend heranreichen.

Wenigstens zum Teil ausgespart bedeutet insbesondere, dass der Lötstopplack vollständig ausgespart und/oder entfernt ist, jedoch ebenso beispielsweise nur zur Hälfte seiner Dicke ausgespart bzw. entfernt sein kann. Ferner sind Ausgestaltungen denkbar, bei denen das elektronische Bauelement an seinem kompletten Rand auf dem Lötstopplack aufliegt und sich die Kanäle zwischen Lötstopplack und Leiterplatte erstrecken.

Sofern sich der ausgesparte Teil nur zwischen einem Kontaktloch bis neben das elektronische Bauelement erstreckt, werden beim Verlöten bevorzugt zunächst die beiden den anderen Kontaktlöchern zugeordneten Drahtanschlüsse verlötet. Da das elektronische Bauelement bei nur zwei verlöteten Drahtanschlüssen noch nicht ortsfest fixiert ist, können Gase zwischen dem elektronischen Bauelement und der Leiterplatte entweichen. Im letzten Schritt wird der mit dem ausgesparten Teil gastechnisch verbundene Drahtanschluss verlötet, so dass Gase durch den ausgesparten Teil entweichen können. Bis neben das elektronische Bauelement bedeutet insbesondere, dass sich der ausgesparte Teil, im Querschnitt, bis seitlich neben ein Gehäuse des elektronischen Bauelements erstreckt, so dass Gas von dem Kontaktloch ungehindert in die Umgebungsluft entweichen kann.

Nach einer bevorzugten Weiterbildung weist der ausgesparte Teil eine Mehrzahl Kanäle auf, die sich jeweils bis neben das elektronische Bauelement erstrecken. Bevorzugt sind die Kanäle in regelmäßigen Abständen angeordnet. Beispielsweise können drei, vier, fünf, sechs, acht, zwölf Kanäle vorgesehen sein. Im Bereich der Kanäle ist der Lötstopplack wenigstens zum Teil ausgespart, während zwischen zwei Kanälen der Lötstopplack vorhanden ist und das elektronische Bauelement insbesondere in diesem Bereich berührend auf dem Lötstopplack und derart auf der Leiterplatte aufliegt. Bevorzugt erstrecken sich die Kanäle wenige Millimeter, insbesondere ein, zwei oder drei Millimeter neben das elektronische Bauelement, so dass derart von den Kontaktlöchern durch die Kanäle hindurch Gas in die Umgebungsluft neben das elektronische Bauelement entweichen kann. Weiter bevorzugt erstrecken sich die Kanäle, insbesondere bezogen auf das elektronische Bauelement, radial von dem elektronischen Bauelement weg. Die Kanäle weisen im Querschnitt beispielsweise eine rechteckige, quadratische, dreieckartige oder halbkreisartige Form auf, welche in die Leiterplatte eingelassen ist. Der ausgesparte Teil lässt sich durch Nichtbelichten des Lötstopplacks, durch wegwaschen desselbigen, durch mechanisches Entfernen beispielsweise durch Fräsen und/oder chemisches Entfernen beispielsweise durch Ätzen herstellen.

Gemäß einer anderen bevorzugten Weiterbildung weist das elektronische Bauelement eine kreisrunde auf der Oberseite aufliegende Grundfläche auf und/oder ist der Lötstopplack unter der Grundfläche kreisrund ausgespart. Beispielweise kann ein Kondensator als elektronisches Bauelement eine kreisrunde Grundfläche aufweisen. Ebenso kann das elektronische Bauelement eine viereckige Grundfläche aufweisen, so dass in diesem Fall der Lötstopplack unter der Grundfläche viereckig ausgespart sein kann. Darüber hinaus sind weitere Ausprägungen der Grundfläche denkbar. Bevorzugt ist der Lötstopplack nicht unter der gesamten Grundfläche ausgespart, so dass das elektronische Bauelement in nicht ausgesparten Bereichen auf dem Lötstopplack aufliegen kann. Bevorzugt liegt das elektronische Bauelement an seinem Rand, nur an seinem Rand oder auf seiner gesamten Grundfläche, sofern darunter nicht der Lötstopplack ausgespart ist, auf der Leiterplatte auf. Bevorzugt erstrecken sich die vorbeschriebenen Kanäle unter dem Rand hindurch.

Nach einer anderen bevorzugten Weiterbildung ist der ausgesparte Teil sternförmig ausgestaltet und erstrecken sich Spitzen des Sterns kanalartig bis neben das elektronische Bauelement. Die Spitzen erstrecken sich insbesondere radial von dem elektronischen Bauelement weg und/oder reichen die Spitzen ein, zwei oder drei Millimeter neben das elektronische Bauelement. Die Spitzen können rund oder spitz zulaufen. Neben einer sternförmigen Ausgestaltung sind weitere Gestaltungen denkbar, bei denen einerseits das elektronische Bauelement berührend auf dem Lötstopplack aufliegt und andererseits der Lötstopplack derart ausgespart ist, dass das Gas von den Kontaktlöchern in die Umgebungsluft entweichen kann. Ferner sind Ausgestaltungen denkbar, bei denen der Lötstopplack unter der Grundfläche kreisrund ausgespart ist und sich der ausgesparte Teil außerhalb der Grundfläche sternförmig über die Grundfläche hinausragt.

Gemäß einer anderen bevorzugten Weiterbildung ist das elektronische Bauelement als Kondensator, insbesondere als Elektrolyt-Kondensator, als Relais, als Transformator, als Spule, als Halbleiter und/oder als integrierter Schaltkreis ausgebildet. Darüber hinaus kann das elektronische Bauelement als weiteres, vorstehend nicht genanntes elektronisches Bauelement mit wenigstens drei Drahtanschlüssen gestaltet sein. Ebenso kann das elektronische Bauelement vier, fünf oder mehr Drahtanschlüsse aufweisen. Die Drahtanschlüsse sind insbesondere beabstandet und/oder in regelmäßigen Abständen angeordnet.

Die Aufgabe wird weiterhin gelöst durch ein Verfahren zum Herstellen einer Kreiselpumpe mit einem Motor, einem von dem Motor antreibbaren Laufrad zum Fördern eines Fluids und einer Steuerung mit einer Leiterplatte, welche Steuerung zum Steuern des Motors eingerichtet ist, mit den Schritten:
Aussparen eines auf einer Oberseite der Leiterplatte vorgesehenen Lötstopplacks in einem Teil, in welchem nachfolgend ein elektronisches Bauelement mit wenigstens drei Drahtanschlüssen aufgesetzt wird, wobei sich der ausgesparte Teil zwischen wenigstens einem und vorzugsweise allen Kontaktlöchern bis neben das aufzusetzende elektronische Bauelement erstreckt,
Aufsetzen des elektronischen Bauelements auf eine Oberseite der Leiterplatte mittels Hindurchführen der Drahtanschlüsse durch Kontaktlöcher, und
Verlöten der Drahtanschlüsse auf der Unterseite mit Leiterbahnen der Unterseite derart, dass das elektronische Bauelement berührend auf dem Lötstopplack aufliegt und von den Kontaktlöchern ein Gas durch den ausgesparten Teil in die Umgebungsluft entweichen kann.

Das Aussparen des Lötstopplacks kann ein schlichtes Weglassen des Lötstopplacks umfassen, welcher von vornherein nur auf Flächen der Leiterplatte appliziert wird, die nicht freibleien sollen, beispielsweise durch Nichtbelichten des Lötstopplacks, oder durch wegwaschen desselbigen. Darüber hinaus ist ein gegebenenfalls zusätzlicher Nachbearbeitungsschritt zum Aussparen denkbar, beispielsweise mechanisches Entfernen durch Fräsen und/oder chemisches Entfernen durch Ätzen.

Nach einer bevorzugten Weiterbildung des Verfahrens weist der ausgesparte Teil eine Mehrzahl Kanäle auf, die sich jeweils bis neben das elektronische Bauelement erstrecken.

Gemäß einer anderen bevorzugten Weiterbildung des Verfahrens weist das elektronische Bauelement eine kreisrunde auf der Oberseite aufliegende Grundfläche auf und/oder ist der Lötstopplack unter der Grundfläche kreisrund ausgespart.

Nach einer noch weiteren bevorzugten Weiterbildung des Verfahrens ist der ausgesparte Teil sternförmig ausgestaltet und erstrecken sich Spitzen des Sterns kanalartig bis neben das elektronische Bauelement.

Gemäß einer anderen bevorzugten Weiterbildung des Verfahrens ist das elektronische Bauelement als Kondensator, insbesondere als Elektrolyt-Kondensator, als Relais, als Transformator, als Spule, als Halbleiter und/oder als integrierter Schaltkreis ausgebildet.

Weitere Ausführungsformen und Vorteile des Verfahrens zum Herstellen der Kreiselpumpe ergeben sich für den Fachmann aus der zuvor beschriebenen Kreiselpumpe.

Die Aufgabe wird weiterhin gelöst durch eine Leiterplatte einer Kreiselpumpe mit einer Oberseite und einer Unterseite, aufweisend
einen wenigstens auf der Oberseite vorgesehenen Lötstopplack, Kontaktlöcher und wenigstens auf der Unterseite vorgesehene Leiterbahnen, und
wenigstens ein auf der Oberseite vorgesehenes elektronisches Bauelement mit wenigstens drei Drahtanschlüssen, welche durch die Kontaktlöcher hindurchgeführt und auf der Unterseite mit den Leiterbahnen derart verlötet sind, dass das elektronische Bauelement berührend auf dem Lötstopplack aufliegt, wobei
der Lötstopplack zwischen dem elektronischen Bauelement und der Leiterplatte wenigstens zum Teil ausgespart ist und sich der ausgesparte Teil zwischen wenigstens einem und vorzugsweise allen Kontaktlöchern bis neben das elektronische Bauelement erstreckt, so dass von den Kontaktlöchern ein Gas in die Umgebungsluft entweichen kann.

Ferner wird die Aufgabe gelöst durch ein Verfahren zum Herstellen einer Leiterplatte mit einer Oberseite und einer Unterseite für eine Kreiselpumpe mit den Schritten:
Aussparen eines auf der Oberseite vorgesehenen Lötstopplacks in einem Teil, in welchem nachfolgend ein elektronisches Bauelement mit wenigstens drei Drahtanschlüssen aufgesetzt wird, wobei sich der ausgesparte Teil zwischen wenigstens einem und vorzugsweise allen Kontaktlöchern bis neben das aufzusetzende elektronische Bauelement erstreckt,
Aufsetzen des elektronischen Bauelements auf die Oberseite mittels hindurchführen der Drahtanschlüsse durch Kontaktlöcher, und
Verlöten der Drahtanschlüsse auf der Unterseite mit Leiterbahnen der Unterseite derart, dass das elektronische Bauelement berührend auf dem Lötstopplack aufliegt und von den Kontaktlöchern ein Gas durch den ausgesparten Teil in die Umgebungsluft entweichen kann.

Weitere Ausführungsformen und Vorteile der Leiterplatte sowie des Verfahrens zum Herstellen der Leiterplatte ergeben sich für den Fachmann aus der zuvor beschriebenen Kreiselpumpe und des Verfahrens zum Herstellen der Kreiselpumpe.

### Kurze Beschreibung der Zeichnungen

Nachfolgend wird die Erfindung unter Bezugnahme auf die anliegenden Zeichnungen anhand bevorzugter Ausführungsbeispiele näher erläutert.

In den Zeichnungen zeigen
- Fig. 1: eine schematisch perspektivische Ansicht eines Ausschnitts einer Leiterplatte einer Kreiselpumpe gemäß einem bevorzugten Ausführungsbeispiel der Erfindung, und
- Fig. 2: eine schematische Draufsicht des Ausschnitts der Leiterplatte der Kreiselpumpe gemäß dem bevorzugten Ausführungsbeispiel der Erfindung.

### Detaillierte Beschreibung der Ausführungsbespiele

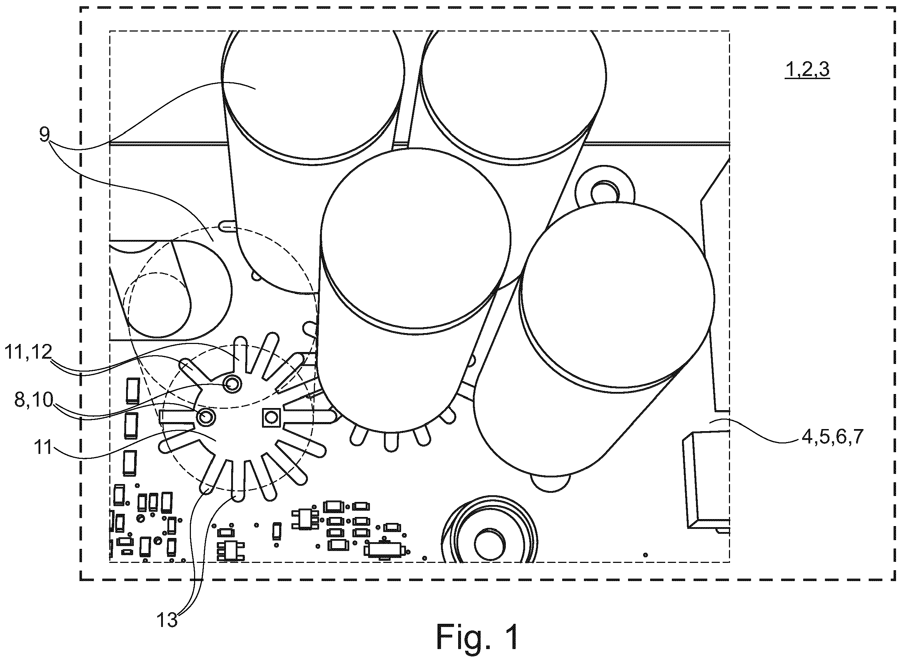

In Fig. 1 zeigt eine Kreiselpumpe 1 mit einem Motor 2, einem von dem Motor 2 antreibbaren Laufrad 3 zum Fördern eines Fluids, jeweils nur schematisch dargestellt, und mit einer Steuerung 4 gemäß einem bevorzugten Ausführungsbeispiel der Erfindung in einer schematisch perspektivischen Ansicht. Konkret zeigt die Ansicht nur einen Teil der Steuerung 4, welche zum Steuern des Motors 2 eingerichtet ist.

Die Steuerung 4 weist eine Leiterplatte 5 auf, auf deren Oberseite 6 mit Lötstopplack 7 versehen ist. Mehrere Kontaktlöcher 8 sind von der Oberseite 6 durch die Leiterplatte 5 hindurch zu einer nicht gezeigten Unterseite der Leiterplatte 5 geführt. Auf der Unterseite der Leiterplatte 5 sin mehrere elektrische leitende, nicht gezeigte Leiterbahnen vorgesehen, die an den Kontaktlöchern 8 münden. Auf der Oberseite 6 der Leiterplatte 5 sind eine Mehrzahl elektronischer Bauelemente 9 vorgesehen, die mit ihrer Unterseite berührend auf der Oberseite 6 aufliegen. Die Steuerung 4 weist neben nachfolgend näher beschriebenen Elektrolyt-Kondensatoren als elektronische Bauelemente 9 einen Mikroprozessor auf, durch welchen der Motor 2 der Kreiselpumpe 1 aufgrund eines vorgegebenen und/oder einstellbaren Programms und/oder aufgrund von Eingangsinformationen wie Sensoren steuerbar ist.

In Fig. 1 sind eine Mehrzahl Elektrolyt-Kondensatoren als elektronische Bauelemente 9 gezeigt, wobei der vorne links gezeigte Elektrolyt-Kondensator transparent dargestellt ist. Jeder Elektrolyt-Kondensator weist drei dreieckartig angeordnete Drahtanschlüsse 10, die durch die Kontaktlöcher 8 hindurchgeführt und an der Unterseite der Leiterplatte 5 mit den Leiterbahnen verlötet sind. Anstelle von Elektrolyt-Kondensatoren können ebenso oder zusätzlich Relais, Transformatoren, Spulen, Halbleiter, integrierte Schaltkreise oder dergleichen vorgesehen sein.

Wie insbesondere aus dem in Fig. 1 vorne links transparent dargestellten Elektrolyt-Kondensator zu erkennen, ist zwischen dem elektronischen Bauelement 9 und der Leiterplatte 5 der Lötstopplack 7 kreisförmig ausgespart. Der kreisförmige ausgesparte Teil 11 umschließt alle drei Kontaktlöcher 8 und erstreckt sich in Kanälen 12, die sich unter dem grundseitigen Rand des Elektrolyt-Kondensator radial weg erstrecken, bis neben das elektronische Bauelement 9. Der kreisförmige ausgesparte Teil 11 weist einen geringeren Durchmesser als die auf der Oberseite 6 aufliegende Grundfläche des elektronischen Bauelements 9 auf. Das elektronische Bauelement 9 liegt an seinem Rand der auf der Oberseite 6 aufliegenden Grundfläche derart abwechselnd berührend auf einem Bereich mit nicht ausgespartem Lötstopplack 7 auf, während angrenzend daran in einem anderen Bereich des Kanals 12 der Lötstopplack 7 ausgespart ist.

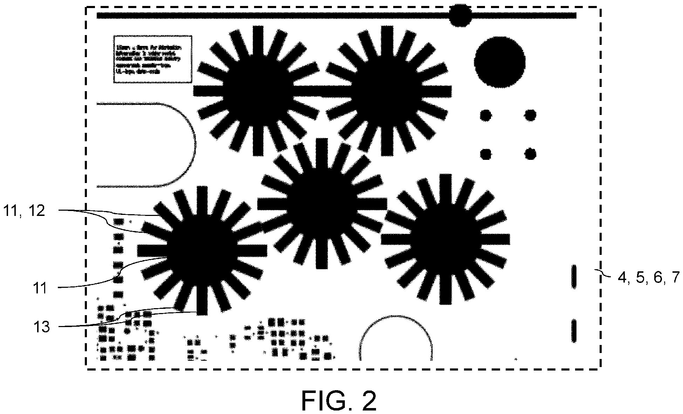

In der in Fig. 2 gezeigten Draufsicht der Leiterplatte 5 aus Fig. 1 mit ausgesparten elektronischen Bauelementen 9 ist zu erkennen, dass sich ausgehend von dem kreisförmigen ausgesparten Teil 11 die Kanäle 12 in regelmäßigen Abständen sternförmig weg bis neben das elektronische Bauelement 9 erstrecken. Spitzen 13 des derart geformten Sterns enden kanalartig neben dem elektronischen Bauelement 9. Durch den ausgesparten die Kanäle 12 einschließenden Teil 11 können beim Verlöten der Drahtanschlüsse 10 mit den Leiterbahnen an den Kontaktlöchern 8 entstehende Gase von der Lötstelle an den Kontaktlöchern 8 zwischen dem elektronischen Bauelement 9 und der Leiterplatte 5 seitlich außerhalb neben das elektronische Bauelement 9 in die Umgebungsluft entweichen. Der ausgesparte Teil 11 verhindert insofern, dass beim Verlöten Gas durch die Kontaktlöcher 8 entweichen und defekte Lötstellen entstehen.

### Bezugszeichenliste

| | |
|---|---|
| Kreiselpumpe | 1 |
| Motor | 2 |
| Laufrad | 3 |
| Steuerung | 4 |
| Leiterplatte | 5 |
| Oberseite | 6 |
| Lötstopplack | 7 |
| Kontaktloch | 8 |
| Elektronisches Bauelement | 9 |
| Drahtanschluss | 10 |
| Ausgesparter Teil | 11 |
| Kanal | 12 |
| Spitze | 13 |

## Patentansprüche

1. Kreiselpumpe (1) mit einem Motor (2), einem von dem Motor (2) antreibbaren Laufrad (3) zum Fördern eines Fluids und einer Steuerung (4), welche zum Steuern des Motors (2) eingerichtet ist, **dadurch gekennzeichnet dass**
die Steuerung (4) eine Leiterplatte (5) mit wenigstens auf einer Oberseite (6) der Leiterplatte (5) vorgesehenem Lötstopplack (7), Kontaktlöcher (8), wenigstens auf einer Unterseite der Leiterplatte (5) vorgesehenen Leiterbahnen und wenigstens ein auf der Oberseite (6) vorgesehenes elektronisches Bauelement (9) mit wenigstens drei Drahtanschlüssen (10) aufweist, welche durch die Kontaktlöcher (8) hindurchgeführt und auf der Unterseite mit den Leiterbahnen derart verlötet sind, dass das elektronische Bauelement (9) berührend auf dem Lötstopplack (7) aufliegt, und
der Lötstopplack (7) zwischen dem elektronischen Bauelement und der Leiterplatte (5) wenigstens zum Teil ausgespart ist und sich der ausgesparte Teil (11) zwischen wenigstens einem Kontaktloch (8) bis neben das elektronische Bauelement (9) erstreckt, so dass von den Kontaktlöchern (8) ein Gas in die Umgebungsluft entweichen kann.

2. Kreiselpumpe (1) nach dem vorhergehenden Anspruch, wobei der ausgesparte Teil (11) eine Mehrzahl Kanäle (12) aufweist, die sich jeweils bis neben das elektronische Bauelement (9) erstrecken.

3. Kreiselpumpe (1) nach einem der vorhergehenden Ansprüche, wobei das elektronische Bauelement (9) eine kreisrunde auf der Oberseite (6) aufliegende Grundfläche aufweist und/oder der Lötstopplack (7) unter der Grundfläche kreisrund ausgespart ist.

4. Kreiselpumpe (1) nach einem der vorhergehenden Ansprüche, wobei der ausgesparte Teil (11) sternförmig ausgestaltet ist und sich Spitzen (13) des Sterns kanalartig bis neben das elektronische Bauelement (9) erstrecken.

5. Kreiselpumpe (1) nach einem der vorhergehenden Ansprüche, wobei das elektronische Bauelement (9) als Kondensator, insbesondere als Elektrolyt-Kondensator, als Relais, als Transformator, als Spule, als Halbleiter und/oder als integrierter Schaltkreis ausgebildet ist.

6. Verfahren zum Herstellen einer Kreiselpumpe (1) mit einem Motor (2), einem von dem Motor (2) antreibbaren Laufrad (3) zum Fördern eines Fluids und einer Steuerung (4) mit einer Leiterplatte (5), welche Steuerung (4) zum Steuern des Motors (2) eingerichtet ist, **dadurch gekennzeichnet, dass** das Verfahren die folgenden Schritte umfasst:
Aussparen eines auf einer Oberseite (6) der Leiterplatte (5) vorgesehenen Lötstopplacks (7) in einem Teil (11), in welchem nachfolgend ein elektronisches Bauelement (9) mit wenigstens drei Drahtanschlüssen (10) aufgesetzt wird, wobei sich der ausgesparte Teil (11) zwischen wenigstens einem Kontaktloch (8) bis neben das aufzusetzende elektronische Bauelement (9) erstreckt,
Aufsetzen des elektronischen Bauelements (9) auf eine Oberseite (6) der Leiterplatte (5) mittels Hindurchführen der Drahtanschlüsse (10) durch Kontaktlöcher (8), und
Verlöten der Drahtanschlüsse (10) auf der Unterseite mit Leiterbahnen der Unterseite derart, dass das elektronische Bauelement (9) berührend auf dem Lötstopplack (7) aufliegt und von den Kontaktlöchern (8) ein Gas durch den ausgesparten Teil (11) in die Umgebungsluft entweichen kann.

7. Verfahren nach dem vorhergehenden Verfahrensanspruch, wobei der ausgesparte Teil (11) eine Mehrzahl Kanäle (12) aufweist, die sich jeweils bis neben das elektronische Bauelement (9) erstrecken.

8. Verfahren nach einem der vorhergehenden Verfahrensansprüche, wobei das elektronische Bauelement (9) eine kreisrunde auf der Oberseite (6) aufliegende Grundfläche aufweist und/oder der Lötstopplack (7) unter der Grundfläche kreisrund ausgespart ist.

9. Verfahren nach einem der vorhergehenden Verfahrensansprüche, wobei der ausgesparte Teil (11) sternförmig ausgestaltet ist und sich Spitzen (13) des Sterns kanalartig bis neben das elektronische Bauelement (9) erstrecken.

10. Verfahren nach einem der vorhergehenden Verfahrensansprüche, wobei das elektronische Bauelement (9) als Kondensator, insbesondere als Elektrolyt-Kondensator, als Relais, als Transformator, als Spule, als Halbleiter und/oder als integrierter Schaltkreis ausgebildet ist.

## Claims

1. A centrifugal pump (1) comprising a motor (2), an impeller (3) driveable by the motor (2) to convey a fluid, and a control unit (4), which is configured to control the motor (2), **characterised in that**
the control unit (4) has a printed circuit board (5) with solder resist (7) provided at least on an upper side (6) of the printed circuit board (5), contact holes (8), conductor tracks provided at least on an underside of the printed circuit board (5), and at least one electronic component (9) provided on the upper side (6) and having at least three wire connections (10), which are guided through the contact holes (8) and are soldered on the underside to the conductor tracks in such a way that the electronic component (9) rests with contact against the solder resist (7), and
the solder resist (7) is recessed at least in part between the electronic component and the printed circuit board (5) and the recessed part (11) extends between at least one contact hole (8) as far as next to the electronic component (9), so that a gas may escape from the contact holes (8) into the ambient air.

2. The centrifugal pump (1) according to the preceding claim, wherein the recessed part (11) has a plurality of channels (12), which each extend as far as next to the electronic component (9).

3. The centrifugal pump (1) according to any one of the preceding claims, wherein the electronic component (9) has a circular base surface resting on the upper side (6) and/or the solder resist (7) is recessed in a circular manner below the base surface.

4. The centrifugal pump (1) according to any one of the preceding claims, wherein the recessed part (11) is star-shaped and points (13) of the star extend in a channel-like manner as far as next to the electronic component (9).

5. The centrifugal pump (1) according to any one of the preceding claims, wherein the electronic component (9) is formed as a capacitor, in particular as an electrolytic capacitor, as a relay, as a transformer, as a coil, as a semiconductor and/or as an integrated circuit.

6. A method for producing a centrifugal pump (1) with a motor (2), an impeller (3) driveable by the motor (2) to convey a fluid, and a control unit (4) with a printed circuit board (5), which control unit (4) is configured to control the motor (2), **characterised in that** the method comprises the following steps:
recessing a solder resist (7) provided on an upper side (6) of the printed circuit board (5) in a part (11) in which an electronic component (9) having at least three wire connections (10) is subsequently placed, wherein the recessed part (11) extends between at least one contact hole (8) as far as next to the electronic component (9) to be placed,
placing the electronic component (9) on an upper side (6) of the printed circuit board (5) by guiding the wire connections (10) through contact holes (8), and
soldering the wire connections (10) on the underside to conductor tracks of the underside, in such a way that the electronic component (9) rests with contact on the solder resist (7) and a gas may escape from the contact holes (8) through the recessed part (11) into the ambient air.

7. The method according to the preceding method claim, wherein the recessed part (11) has a plurality of channels (12), which each extend as far as next to the electronic component (9).

8. The method according to any one of the preceding method claims, wherein the electronic component (9) has a circular base surface resting on the upper side (6) and/or the solder resist (7) is recessed in a circular manner below the base surface.

9. The method according to any one of the preceding method claims, wherein the recessed part (11) is star-shaped and points (13) of the star extend in a channel-like manner as far as next to the electronic component (9).

10. The method according to any one of the preceding method claims, wherein the electronic component (9) is formed as a capacitor, in particular as an electrolytic capacitor, as a relay, as a transformer, as a coil, as a semiconductor and/or as an integrated circuit.

## Revendications

1. Pompe centrifuge (1) comprenant un moteur (2), une turbine (3) pouvant être entraînée par le moteur (2) pour transporter un fluide, et une unité de commande (4), qui est configurée pour commander le moteur (2), **caractérisée en ce que**
l'unité de commande (4) a une carte de circuit imprimé (5) avec un vernis-épargne (7) pourvu au moins sur un côté supérieur (6) de la carte de circuit imprimé (5), des orifices de contact (8), des pistes conductrices pourvues au moins sur un côté inférieur de la carte de circuit imprimé (5), et au moins un composant électronique (9) pourvu sur le côté supérieur (6) et ayant au moins trois connexions filaires (10), qui sont guidées à travers les orifices de contact (8) et sont brasées sur le côté inférieur aux pistes conductrices d'une manière telle que le composant électronique (9) repose en contact contre le vernis-épargne (7), et
le vernis-épargne (7) est rétracté au moins en partie entre le composant électronique et la carte de circuit imprimé (5) et la partie rétractée (11) s'étend entre au moins un orifice de contact (8) jusqu'à proximité du composant électronique (9), de sorte qu'un gaz peut s'échapper des orifices de contact (8) dans l'air ambiant.

2. Pompe centrifuge (1) selon la revendication précédente, dans laquelle la partie rétractée (11) a une pluralité de canaux (12), qui s'étendent chacun jusqu'à proximité du composant électronique (9).

3. Pompe centrifuge (1) selon l'une quelconque des revendications précédentes, dans laquelle le composant électronique (9) a une surface de base circulaire reposant sur le côté supérieur (6) et/ou le vernis-épargne (7) est rétracté d'une manière circulaire sous la surface de base.

4. Pompe centrifuge (1) selon l'une quelconque des revendications précédentes, dans laquelle la partie rétractée (11) est en forme d'étoile et les pointes (13) de l'étoile s'étendent de manière semblable à des canaux jusqu'à proximité du composant électronique (9).

5. Pompe centrifuge (1) selon l'une quelconque des revendications précédentes, dans laquelle le composant électronique (9) est formé en tant que condensateur, en particulier en tant que condensateur électrolytique, en tant que relais, en tant que transformateur, en tant que bobine, en tant que semi-conducteur et/ou en tant que circuit intégré.

6. Procédé de production d'une pompe centrifuge (1) avec un moteur (2), une turbine (3) pouvant être entraînée par le moteur (2) pour transporter un fluide, et une unité de commande (4) avec une carte de circuit imprimé (5), laquelle unité de commande (4) est configurée pour commander le moteur (2), **caractérisée en ce que** le procédé comprend les étapes suivantes :
rétracter un vernis-épargne (7) pourvu sur un côté supérieur (6) de la carte de circuit imprimé (5) dans une partie (11) dans laquelle un composant électronique (9) ayant au moins trois connexions filaires (10) est ensuite placé, dans lequel la partie rétractée (11) s'étend entre au moins un orifice de contact (8) jusqu'à proximité du composant électronique (9) à placer,
placer le composant électronique (9) sur un côté supérieur (6) de la carte de circuit imprimé (5) en guidant les connexions filaires (10) à travers les offices de contact (8), et
braser les connexions filaires (10) sur le côté inférieur aux pistes conductrices du côté inférieur, d'une manière telle que le composant électronique (9) repose en contact sur le vernis-épargne (7) et un gaz peut s'échapper des orifices de contact (8) à travers la partie rétractée (11) dans l'air ambiant.

7. Procédé selon la revendication de procédé précédente, dans lequel la partie rétractée (11) a une pluralité de canaux (12), qui s'étendent chacun jusqu'à proximité du composant électronique (9).

8. Procédé selon l'une quelconque des revendications de procédé précédentes, dans lequel le composant électronique (9) a une surface de base circulaire reposant sur le côté supérieur (6) et/ou le vernis-épargne (7) est rétracté d'une manière circulaire sous la surface de base.

9. Procédé selon l'une quelconque des revendications de procédé précédentes, dans lequel la partie rétractée (11) est en forme d'étoile et les pointes (13) de l'étoile s'étendent de manière semblable à des canaux jusqu'à proximité du composant électronique (9).

10. Procédé selon l'une quelconque des revendications de procédé précédentes, dans lequel le composant électronique (9) est formé en tant que condensateur, en particulier en tant que condensateur électrolytique, en tant que relais, en tant que transformateur, en tant que bobine, en tant que semi-conducteur et/ou en tant que circuit intégré.
